# EUROPEAN PATENT APPLICATION

(11) **EP 4 621 852 A1**
(43) Date of publication of application: **24.09.2025**
(21) Application number: 24164888.0
(22) Date of filing: 20.03.2024
(51) Int. Cl.: H01L 29/40, H01L 29/41, H01L 29/417, H01L 29/423, H01L 29/66, H01L 29/78

(54) **SEMICONDUCTOR DEVICE AND METHOD OF FORMING SELF-ALIGNED CONTACT IN SEMICONDUCTOR DEVICE**

(71) Applicant: Nexperia B.V., 6534 AB Nijmegen (NL)
(72) Inventor: Wang, Zhengkang, Shanghai (CN); Kim, Hungjin, Shanghai (CN); Yu, Zheng, Shanghai (CN)
(74) Representative: Pjanovic, Ilija

(57) **Abstract**

A method of forming a self-aligned contact in a semiconductor device. A semiconductor structure is obtained. The semiconductor structure includes a substrate with a surface, and a trench extending in a first direction from the surface into the substrate. The surface includes a first portion etched to form a divot and an adjacent second portion. An electrode is arranged in the trench. A dielectric is arranged on the semiconductor structure to cover a wall of the divot and the second portion of the surface. Impurities of different conductivity types are implanted in the substrate to form first and second regions of different conductivity types in the substrate. The first region is spatially aligned with the electrode in a second direction perpendicular to the first direction. The second region is arranged between the first region and the dielectric. Part of the dielectric is removed to expose part of the second region. The exposed part of the second region and a corresponding part of the first region are etched to form an opening that extends in the first direction into the first and second regions. A third region of the same conductivity type as and has a higher level of conductivity than the first region is formed in part of the first region. The third region is spatially aligned with the first region and the electrode in the second direction. The third region provides a wall portion of the opening and is operable as a contact of the semiconductor device.

## Description

### TECHNICAL FIELD

Embodiments described herein relate to a semiconductor device and a method of forming a self-aligned contact in a semiconductor device.

### BACKGROUND

Semiconductor devices such as metal oxide semiconductor field effect transistors (MOSFET) are known. Typically, a semiconductor device includes multiple cells arranged in parallel. The performance of the semiconductor device can be affected by various critical design parameters.

One example critical design parameter is cell pitch. Ideally, the cell pitch of the semiconductor device should be small so that the cells can be compactly arranged to reduce drain-source specific on-resistance R_{on,sp} of the semiconductor device. Problematically, existing semiconductor device manufacturing processes limits the extent of which the cell pitch can be reduced.

In trench-based semiconductor devices, example critical design parameters include trench critical dimension and mesa critical dimension. The trench critical dimension may be limited by, e.g., dielectric and conductive material filling capabilities of the trench. The mesa critical dimension may be limited by, e.g., critical dimension of the contact, amount of spacing between the contact and the trench, and contact misalignment associated with the use of lithographical (e.g., photolithographical) techniques and tools during manufacturing, which may undesirably affect the threshold voltage Vₜₕ (i.e., minimum gate-to-source voltage V_{GS(th)}) of the cell and/or the semiconductor device.

### SUMMARY

In a first aspect, there is provided a method of forming a self-aligned contact in a semiconductor device. The method includes: (a) obtaining a semiconductor structure, which includes a substrate with a surface, and a trench extending in a first direction from the surface into the substrate. The surface includes a first portion etched to form a divot and a second portion adjacent the first portion. The method further includes: (b) arranging an electrode in the trench, and (c) arranging a dielectric on the semiconductor structure to cover, at least, a wall of the divot provided by the substrate and the second portion of the surface. The method further includes: (d) implanting, in the substrate, impurities of a first conductivity type and a second conductivity type to form a first region of the first conductivity type and a second region of the second conductivity type. The first region is spatially aligned with the electrode in a second direction perpendicular to the first direction. The second region is arranged between the first region and the dielectric. The method further includes: (e) removing part of the dielectric to expose part of the second region, and (f) etching the exposed part of the second region and a corresponding part of the first region to form an opening that extends in the first direction into the first and second regions. The method further includes: (g) forming, in part of the first region, a third region of the first conductivity type with a higher level of conductivity than the first region. The third region is spatially aligned with the first region and the electrode in the second direction, and the third region provides a wall portion of the opening for operating as a contact of the semiconductor device. The first conductivity type is one of a p-type and n-type, and the second conductivity type is another one of p-type and n-type.

In the method, at least the divot provided by the substrate, and hence a corresponding part of the substrate, are covered by dielectric during the etching of the first and second regions (for forming the opening). In other words, the dielectric can act as a mask to shield or protect the corresponding part of the substrate from the etching.

As a result of such shielding, the contact (i.e., third region) subsequently formed is spaced from the first electrode and can be spatially aligned with the first electrode and the first region. The contact (i.e., third region) can thus be considered as a self-aligned contact. Also, the etching for forming the opening can be performed without using lithographical mask hence without requiring associated alignment.

In some embodiments, the spacing of the contact (i.e., third region) from the first electrode can help to reduce threshold voltage Vₜₕ (i.e., minimum gate-to-source voltage V_{GS(th)}) shift induced by the forming of the third region (i.e., contact). In some embodiments, the spatial alignment of the first and third regions and the electrode enables a more effective operational coupling among the first and third regions and the electrode. In some embodiments, as the lithographical alignment hence the associated allowance is not required, the number of process step and/or time required to form the opening or the contact (i.e., third region) can be reduced. In some embodiments, as the lithographical alignment hence the associated allowance is not required, a critical dimension of the mesa region (the region between the trenches of the two cells in the second direction) can be small, and the pitch of a cell (i.e., a basic repeating unit) of the semiconductor device can be small. A small cell pitch enables manufacturing of a semiconductor device with high cell density, hence may provide a semiconductor device with improved (reduced) drain-source specific on-resistance R_{on,sp}.

In one example, the pitch of the cell is less than 0.9 microns. In another example, the pitch of the cell is less than 0.8 microns. Depending on applications, the pitch of the cell can have a different value.

Preferably, the substrate is a silicon substrate. The silicon substrate may be readily obtained and processed using existing semiconductor manufacturing techniques (e.g., etching techniques, deposition techniques, oxidation techniques, etc.). In some embodiments, the silicon substrate includes n-type silicon. In some embodiments, the silicon substrate includes p-type silicon.

In some embodiments, the semiconductor structure obtained in (a) further includes: a second electrode and a dielectric arrangement arranged on a base wall and a sidewall of the trench. The dielectric arrangement surrounds the second electrode in the trench. In some embodiments, the second electrode has a polysilicon body and/or is operable as a shield electrode or shield plate. In some embodiments, the dielectric arrangement is an oxide arrangement (e.g., silicon dioxide). In some embodiments, the dielectric arrangement is operable as a shield dielectric and an inter-electrode (or inter-poly) dielectric. In some embodiments, the dielectric arrangement is further operable as a gate dielectric.

In some embodiments, obtaining the semiconductor structure in (a) includes: (i) obtaining a semiconductor structure that includes the substrate, a mask formed on the surface of the substrate, and the trench extending in the first direction through the mask and into the substrate, (ii) removing a first part of the mask to expose the first portion of the surface, (iii) etching the exposed first portion of the surface to form the divot when the second portion of the surface is covered by a second part of the mask, and (iv) removing the second part of the mask to expose the second portion of the surface.

In some embodiments, the first part of the mask is arranged at an open end of the trench.

In some embodiments, removing the first part of the mask includes etching the mask.

In some embodiments, removing the second part of the mask includes etching the mask.

In some embodiments, the mask is a hard mask such as an oxide-nitride-oxide (ONO) hard mask. For example, the mask may include: a silicon oxide layer disposed on the surface of the substrate, a silicon nitride layer disposed on the silicon oxide layer, and a further silicon oxide layer disposed on the silicon nitride layer. For example, removing the first part of the mask may include: etching part of the silicon oxide layer, etching part of the silicon nitride layer, and etching part of the further silicon oxide layer. For example, removing the second part of the mask may include etching another part of the silicon oxide layer, etching another part of the silicon nitride layer, and etching another part of the further silicon oxide layer.

In some embodiments, the divot is integrated with the trench to provide an enlarged mouth portion at an open end of the trench. In some embodiments, the enlarged mouth portion is a stepped portion.

In some embodiments, arranging the first electrode in the trench in (b) includes depositing polysilicon in a space defined by the dielectric arrangement. In some embodiments, the first electrode has a polysilicon body and/or is operable as a gate electrode. In some embodiments, the deposited first electrode is spaced apart from the trench wall by the dielectric arrangement, which includes a portion operable as gate dielectric.

In some embodiments, arranging the dielectric on the semiconductor structure in (c) includes: arranging the dielectric on the semiconductor structure obtained after (b) to cover the first electrode, the wall of the divot provided by the substrate, and the second portion of the surface. In some embodiments, the dielectric may cover further structures. In some embodiments, arranging the dielectric on the semiconductor structure in (c) includes depositing the dielectric. In some embodiments, the dielectric is an oxide (e.g., silicon dioxide).

In some embodiments, the forming in (g) includes: implanting, in the substrate and in the first region, impurities of the same conductivity type as and a higher doping level than the first region to form the third region.

In some embodiments, the first region is a p-type region, the second region is a n-type region, and the third region is a p-type region (e.g., p+ region). A p-n junction is defined by the first region and the second region.

In some embodiments, the method further includes, after the implanting in (d) and prior to the removing in (e), depositing a dielectric material on the semiconductor structure to fill the remaining space of the trench. In some embodiments, the deposition of the dielectric material may continue after the trench is filled. In some embodiments, the dielectric material is oxide (e.g., silicon dioxide) and/or the deposited dielectric material is operable as inter layer dielectric. In some embodiments, the method further includes, forming a barrier layer on the deposited dielectric material. In some embodiments, the barrier layer is a silicon nitride layer and/or the barrier layer is formed by deposition.

In some embodiments, the method further includes, after the implanting in (d) and prior to the removing in (e), forming a barrier layer on the semiconductor structure to cover the remaining space of the trench, and depositing a dielectric material on the barrier layer to fill the remaining space of the trench. In some embodiments, the barrier layer is a silicon nitride layer and/or the barrier layer is formed by deposition. In some embodiments, the deposition of the dielectric material may continue after the trench is filled. In some embodiments, the dielectric material is oxide (e.g., silicon dioxide) and/or the deposited dielectric material is operable as inter layer dielectric.

In some embodiments, the semiconductor device is a trench gate semiconductor device, e.g., a trench gate MOSFET, which may be particularly suitable for low voltage applications.

In some embodiments, the semiconductor device is a shielded gate trench (SGT) semiconductor device, e.g., a SGT MOSFET, which may be particularly suitable for low voltage applications.

In a second aspect, there is provided a semiconductor device including a contact formed using the method of the first aspect. In some embodiments, the semiconductor device includes multiple ones of the contact formed using the method of the first aspect.

In a third aspect, there is provided an electrical device or system that includes the semiconductor device of the second aspect.

Other features and aspects will become apparent by consideration of the detailed description and accompanying drawings. Any feature(s) described in relation to one aspect or example may be combined with any other feature(s) described in relation to any other aspect or example as appropriate and applicable.

Terms of degree such as "generally", "about", "substantially", or the like, are used, depending on context, to account for one or more of the following: manufacture tolerance, degradation, trend, tendency, or imperfect practical condition(s).

Unless otherwise specified, terms such as "connected", "coupled", or "mounted", are intended to cover both direct and indirect "connection", "coupling", or "mounting".

### BRIEF DESCRIPTION OF THE DRAWINGS

Embodiments of the invention will now be described, by way of example, with reference to the accompanying drawings (which may not be drawn to scale) in which:
Fig. 1 is a flowchart showing a method of forming a self-aligned contact in a semiconductor device in one embodiment of the invention;
Figs. 2A to 2O are schematic diagrams illustrating a method of forming a self-aligned contact in a shielded gate trench (SGT) MOSFET (only one cell is shown) in one embodiment of the invention;
Fig. 3A is a schematic diagram illustrating a variation to the stage of the method shown in Fig. 2L in one embodiment of the invention;
Fig. 3B is a schematic diagram illustrating a variation to the stage of the method shown in Fig. 2L in one embodiment of the invention;
Figs. 4A to 4H are schematic diagrams illustrating part of a method of forming a self-aligned contact in a SGT MOSFET (only one cell is shown) in one embodiment of the invention;
Fig. 5 is a schematic diagram of a cell of a SGT MOSFET formed using the method of Figs. 2A to 2O in one embodiment of the invention; and
Fig. 6 is a schematic diagram of a SGT MOSFET with a cell array formed by multiple ones of the cell of Fig. 5 in one embodiment of the invention.

### DETAILED DESCRIPTION

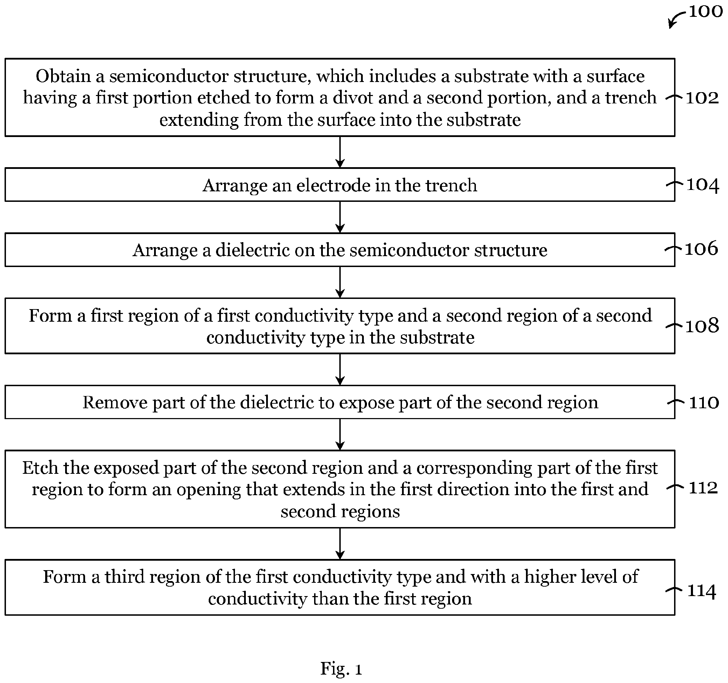

Fig. 1 illustrates a method 100 of forming a self-aligned contact in a semiconductor device in one embodiment of the invention. The method 100 includes various steps 102-114 illustrating the main operations. Each of the steps 102-114 may include one or more further operations not specifically illustrated. The method 100 may include one or more further steps not specifically illustrated. The semiconductor device in this embodiment is a trench-type semiconductor device, such as a trench gate semiconductor device or a shielded gate trench (SGT) semiconductor device.

In step 102, a semiconductor structure is first obtained. This semiconductor structure includes a substrate, such as a silicon substrate, with a surface, and a trench extending in a first direction (e.g., vertical direction) from the surface into the substrate. The surface includes a first portion etched to form a divot and a second portion adjacent the first portion. In one example, the trench includes an electrode, e.g., a polysilicon body, and a dielectric arrangement, e.g., an oxide arrangement, arranged on a base wall and a sidewall of the trench. The dielectric arrangement surrounds the electrode to space the electrode apart from the trench walls. For example, the dielectric arrangement may have been formed on the trench walls by oxidation and/or deposition. In one example, the divot is integrated with the trench to provide an enlarged mouth portion, e.g., a stepped portion, at an open end of the trench.

In step 104, an electrode, e.g., a polysilicon body, is arranged in the trench. The electrode may be spaced apart from the trench walls by the dielectric arrangement. In one example, step 104 includes depositing polysilicon in a space defined by the dielectric arrangement.

In step 106, a dielectric, e.g., oxide, is arranged on the semiconductor structure to cover a wall of the divot provided by the substrate and the second portion of the surface. The dielectric may further cover the electrode arranged in the trench in step 104. In one example, step 106 includes forming the dielectric by oxidation and/or deposition. In one example, the dielectric is arranged to cover all exposed surfaces on one side of the substrate.

In step 108, a first region of a first conductivity type (one of a p-type and n-type) and a second region of a second conductivity type (another one of p-type and n-type) are formed in the substrate, in particular adjacent to the dielectric covering the wall of the divot and the second portion of the surface, by implanting impurities of the first and second conductivity types in the substrate. The two regions are formed such that: the first region is spatially aligned with the electrode formed in step 104 in a second direction (e.g., lateral/horizontal direction) perpendicular to the first direction, and the second region is arranged between the first region and the dielectric.

In step 110, part of the dielectric formed in step 106 is removed, e.g., by etching, to expose part of the second region, and part of the dielectric formed in step 106 remains.

In step 112, the exposed part of the second region and a corresponding (e.g., underlying) part of the first region are (or more generally, the substrate is) etched to form an opening. The opening extends in the first direction into the first and second regions, and terminates in the first region. As some of the dielectric is not removed in step 110, the dielectric that remains covers corresponding parts of the substrate to shield those parts from the etching. In other words, the dielectric that remains acts as a shield for the substrate so the etching in step 112 can be performed without using lithographical techniques and tools.

In step 114, a third region is formed in the first region. The third region is of the same conductivity type as and has a higher level of conductivity than the first region. In one example, the third region is formed by implanting corresponding level of impurities (higher level than the first region) in the substrate in the first region. The third region is spatially aligned with the first region and the electrode in the second direction, and the third region provides part of a wall portion of the opening for operating as a contact of the semiconductor device.

It should be appreciated that the order of the steps in the method 100 can be modified to provide other embodiments of the invention. For example, in one embodiment, step 106 can be performed after step 108.

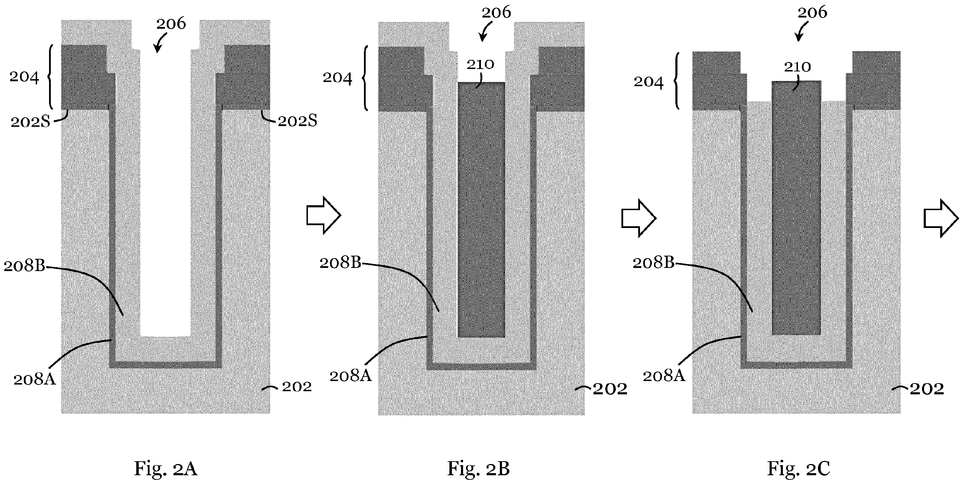

Figs. 2A to 2O illustrate various stages in a method of forming a self-aligned contact in a shielded gate trench (SGT) MOSFET (only one cell is shown) in one embodiment of the invention. The method illustrated using Figs. 2A to 2O can be considered as a more specific implementation example of the method 100 of Fig. 1.

Figs. 2A to 2I illustrate example operations of step 102 in method 100.

In the stage shown in Fig. 2A, a semiconductor structure is initially provided. The semiconductor structure includes a n-type (silicon) epitaxial substrate 202 with a top surface 202S, an oxide-nitride-oxide (ONO) hard mask 204 formed on the top surface 202S, and a trench 206 extending through the hard mask 204 and into the substrate 202 in the vertical direction. The hard mask includes an upper oxide (silicon oxide) layer, a middle silicon nitride layer, and a lower oxide (silicon oxide) layer. The semiconductor structure is processed to form a liner dielectric. Specifically, the semiconductor structure is first subjected to thermal oxidation, to form a thin oxide (silicon dioxide) lining 208A on the walls of the trench 206 provided by the substrate 202. The oxide of the thin oxide lining 208A can be referred to as thermal oxide, and can be considered as a pre-liner layer. Then, oxide is deposited, e.g., isotropically, on the resulting semiconductor structure to form a thick oxide layer 208B that covers the thin oxide lining 208A and the hard mask 204. The deposition can be performed using chemical vapor deposition such as sub-atmospheric chemical vapor deposition (SACVD). The thick oxide layer 208B is then densified by heating. The thin oxide lining 208A and the thick oxide layer 208B provide the liner dielectric.

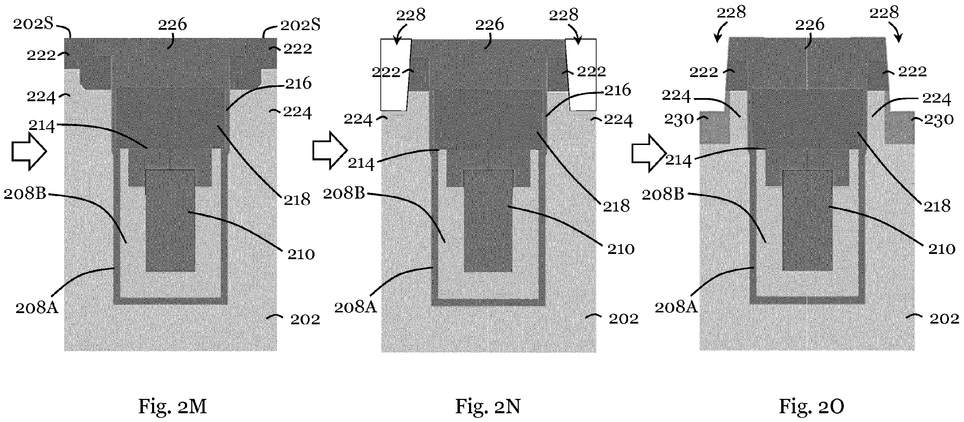

In the stage shown in Fig. 2B, n-type (n+) polysilicon is deposited into the trench 206, in a space in the trench 206 defined by the thick oxide layer 208B. The deposited polysilicon is then subjected to chemical mechanical polishing and/or is etched back, to form a polysilicon body 210.

In the stage shown in Fig. 2C, the semiconductor structure is wet etched (oxide etching) to remove part of the thick oxide layer 208B and part of the upper oxide layer of the mask 204. With part of the thick oxide layer 208B on the mask 204 and part of the thick oxide layer 208B in the upper portion of the trench 206 removed, the polysilicon body 210 projects beyond the space defined by the thick oxide layer 208B.

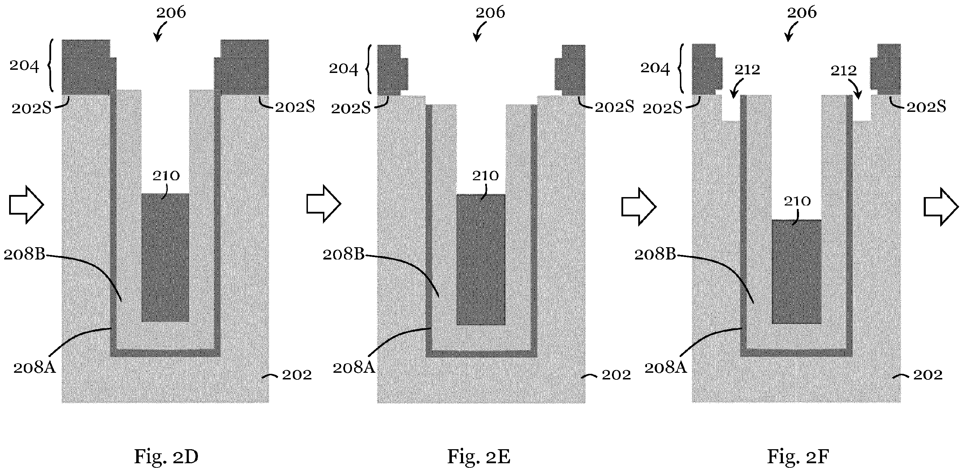

In the stage shown in Fig. 2D, a photoresist is applied to the semiconductor structure, and a photolithographic mask (patterned) is applied over the semiconductor structure. With the photoresist and photolithographic mask applied, the polysilicon body 210 is then etched to remove part of the polysilicon body 210. The resulting polysilicon body 210 is disposed away from the top end of the trench 206, with the top end of the resulting polysilicon body 210 located deeper in the trench 206. After the etching, the photoresist is stripped.

In the stage shown in Fig. 2E, a pull-back operation is performed to remove part of the hard mask 204 to expose part of the top surface 202S at the open end of the trench 206. Specifically, the part of the hard mask 204 on the top surface 202S closest to the space of the trench is removed. The pull-back operation includes wet etching the middle silicon nitride layer of the hard mask 204 to remove part of the middle silicon nitride layer of the hard mask 204 laterally closest to the trench 206 and wet etching the upper and lower oxide layers of the hard mask 204 to remove part of the upper and lower oxide layers of the hard mask 204 laterally closest to the trench 206. As part of the wet etching process, part of the thin oxide lining 208A and part of the thick oxide layer 208B in the upper portion of the trench 206 are also etched.

In the stage shown in Fig. 2F, the semiconductor structure is etched (silicon etching) to remove exposed parts of the substrate 202. In particular, a silicon etching operation is performed on the semiconductor structure such that the exposed parts of the substrate 202 on the top side of the semiconductor structure are removed. The other parts of the top surface 202S on the top side of the semiconductor structure are shielded by the hard mask 204 from the etching hence is not removed by the silicon etching operation. The liner oxide (thin oxide lining 208A and the thick oxide layer 208B) is also substantially unaffected by the silicon etching operation. The silicon etching operation results in the formation of divots 212 (defined by the remaining substrate 202) at the open end of the trench 206. The divot 212 is continuous with the trench 206 and defines an enlarged, stepped portion of the trench 206. As part of the silicon etching operation, part of the polysilicon body 210 is also etched hence removed. After silicon etching operation, the semiconductor structure is cleaned.

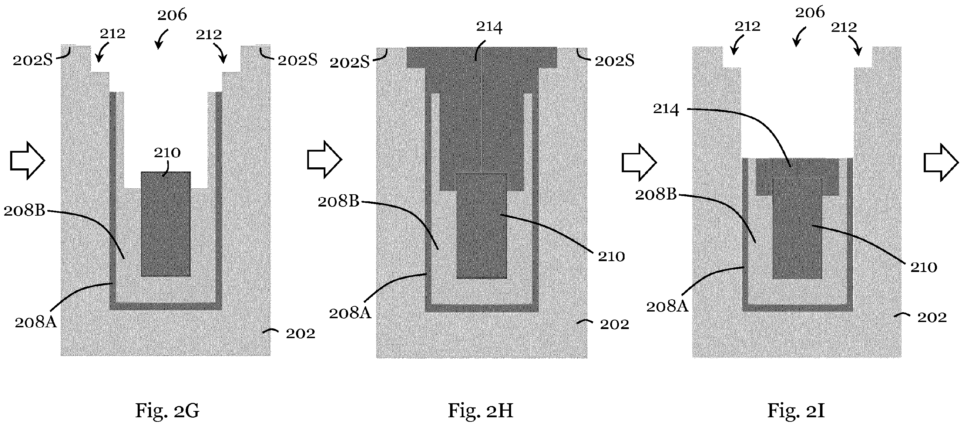

In the stage shown in Fig. 2G, the remaining hard mask 204 on the substrate 202 is removed. Specifically, the hard mask 204 is removed by wet etching the remaining middle silicon nitride layer of the hard mask 204 and wet etching the remaining upper and lower oxide layers of the hard mask 204. As part of the process, part of the thin oxide lining 208A and part of the thick oxide layer 208B in the trench 206 are also etched hence removed. After the etching, the semiconductor structure is cleaned.

In the stage shown in Fig. 2H, an oxide (silicon dioxide) is arranged to fill the remaining space of the trench 206. In one example, the arrangement of the oxide 214 to fill the trench 206 includes depositing oxide into the trench 206 then performing chemical mechanical polishing on the deposited oxide such that the top surface of the oxide 214 is generally flush with the surface 202S of the substrate 202. The oxide deposition can be performed using chemical vapor deposition techniques such as sub-atmospheric chemical vapor deposition, high density plasma chemical vapor deposition, low pressure chemical vapor deposition, etc. In another example, the arrangement of the oxide to fill the trench 206 includes depositing oxide (e.g., using the above described techniques) into the trench 206 then performing (partial) chemical mechanical polishing and subsequently etching on the deposited oxide such that the top surface of the oxide 214 is generally flush with the surface 202S of the substrate 202. After these operations, the semiconductor structure is cleaned.

In the stage shown in Fig. 2I, a photoresist is applied to the semiconductor structure, and a photolithographic mask (patterned) is applied over the semiconductor structure. With the photoresist and photolithographic mask applied, the oxide 214 is wet etched. As part of the process, part of the thin oxide lining 208A and part of the thick oxide layer 208B in the trench 206 are also etched (oxide etching) hence removed. The oxide 214, the thin oxide lining 208A, and the thick oxide layer 208B that remains in the trench 206 defines a generally flat top surface. After the etching, the photoresist is stripped.

The semiconductor structure obtained in each of the stages in Figs. 2G, 2H, and 2I includes a substrate 202 with a surface 202S, and a trench 206 extending in the vertical direction from the surface 202S into the substrate 202. The surface 202S includes a first portion etched to form a divot 212 and a second portion adjacent the first portion.

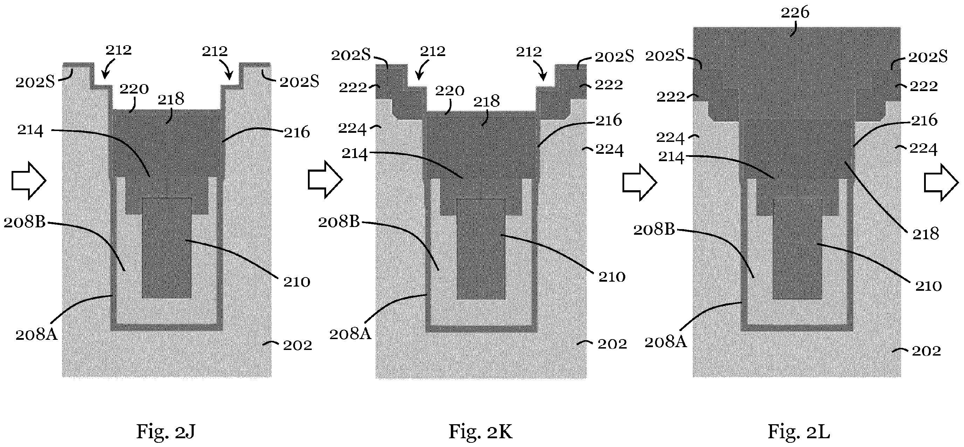

Fig. 2J illustrates example operations of step 104 and step 106 in method 100.

In the stage shown in Fig. 2J, a thin oxide (silicon dioxide) layer 216 is first formed on the exposed parts on the top side of the substrate 202 by thermal oxidation. Then, n-type (n+) polysilicon is deposited into the trench 206, in a space defined by the thin oxide layer 216 to form a polysilicon body 218, which is spaced apart from the trench walls by the thin oxide layer 216. The polysilicon body 218 is then subjected to chemical mechanical polishing. A photoresist is applied to the semiconductor structure, and a photolithographic mask (patterned) is applied over the semiconductor structure. With the photoresist and photolithographic mask applied, the polysilicon body 218 is etched to remove part of the polysilicon body 218 such that the resulting polysilicon body 218 is disposed away from divot 212 (the top surface of the resulting polysilicon body 218 is below the surface of the divot). After the etching, the photoresist used for the etching is stripped. The thin oxide (silicon dioxide) layer 216 is then wet etched (oxide etching), and a sacrificial oxide layer 220 is formed to cover the exposed parts on the top side of the substrate 202.

The semiconductor structure obtained in the stage in Figs. 2J includes an electrode, provided by the polysilicon body 218, arranged in the trench 206, and a dielectric, provided by the layer 220, arranged on the semiconductor structure to cover the wall of the divot 212 and the second portion of the surface.

Fig. 2K illustrates example operation of step 108 in method 100.

In the stage shown in Fig. 2K, p-type impurities are implanted (i.e., doped) into the part of the substrate in a region under the surface 202S and the divot 212, then annealing is performed. Further, n-type impurities are implanted (i.e., doped) into the part of the substrate in a region under the surface 202S and the divot 212, then annealing is performed. As a result, p-type region 224 is formed laterally adjacent the polysilicon body 218, and a n-type (n+) region 222 is formed between the p-type region 224 and the dielectric on the surface 202S and the divot 212. In this example, due to the presence of the divot 212, which provides a stepped portion at the top end of the trench, the formed n-type (n+) region 222 has a correspondingly stepped portion or form. A p-n junction is formed between the two regions 222, 224.

The semiconductor structure obtained in the stage in Fig. 2K includes a first region of the first conductivity type, provided by the p-type region 224, and a second region of the second conductivity type, provided by the n-type region 222. The p-type region 224 is spatially aligned with the polysilicon body 218 in a lateral direction. The n-type region 222 is arranged between the p-type region 224 and the dielectric provided by the sacrificial oxide layer 220.

Figs. 2L and 2M illustrate example operation of step 110 in method 100.

In the stage shown in Fig. 2L, oxide (silicon dioxide) is deposited in the trench 206 on the sacrificial oxide layer 220, to fill the remaining space of the trench 206. The deposited oxide 226 is then subjected to (partial) chemical mechanical polishing, so that the top surface of the oxide 226 is generally flush with the surface 202S of the substrate 202. Then, oxide (silicon dioxide) is further deposited isotropically to cover the top surface of the semiconductor structure, to form a larger oxide 226 on the top of the semiconductor structure.

In the stage shown in Fig. 2M, a photoresist is applied to the semiconductor structure, and a photolithographic mask (patterned) is applied over the semiconductor structure. With the photoresist and photolithographic mask applied, the oxide 226 and the sacrificial oxide layer 220 are etched, to remove the oxide above the level of the surface 202S. The oxide etching terminates on the surface 202S. The remaining oxide 226 fills the space of the trench 206. The surface 202S of the substrate, i.e., the surface of the n-type region 222, is exposed. After the etching, the photoresist is stripped.

The semiconductor structure obtained in the stage in Fig. 2M includes an exposed surface or part of the n-type region 222, which is exposed by etching, or more generally removing, part the dielectric formed.

Fig. 2N illustrates example operation of step 112 in method 100.

In the stage shown in Fig. 2N, silicon etching is performed. Specifically, the surface 202S of the substrate, which is also the surface of the n-type region 222, is etched, and the corresponding part of the n-type region 222 and an underlying part of the p-type region 224 are removed, to form an opening (moat) 228. The wall of the opening is provided by the n-type region 222 and the p-type region 224. In the etching, other parts of substrate covered by the oxide 226 is shielded from the etching by the oxide 226 hence is not removed. After the etching, the photoresist is stripped.

In the semiconductor structure obtained in the stage in Fig. 2N, part of the n-type region 222 and a corresponding part of the p-type region 224 are etched to form the opening 228 that extends in the vertical direction into the n-type and p-type regions 222, 224 while other parts of the substrate is covered by dielectric (e.g., oxide).

Fig. 2O illustrates example operation of step 114 in method 100.

In the stage shown in Fig. 2O, p-type impurities of higher doping level or concentration than the p-type region 224 are implanted (i.e., doped) into the substrate in part of the p-type region 224. Then, annealing is performed. As a result, a p+ region 230 is formed. The p+ region 230 is arranged at generally the same height or depth as the p-type region 224 and the polysilicon body 218. The walls of the opening 228 is provided partly by the p+ region 230 (the lower wall portions) and partly by the n-type region 222 (the upper wall portions).

The semiconductor structure obtained in the stage in Fig. 2O includes a p+ region 230 formed in part of the p-type region 224. The p+ region 230 is more conductive than the p-type region 224. The p+ region 230 is spatially aligned with the p-type region 224 and the polysilicon body 218 in the lateral direction. The p+ region 230 provides a wall portion of the opening 228 for operating as a contact of the semiconductor device/structure.

After the stage shown in Fig. 2O, metallic material can be deposited on the semiconductor structure to fill the opening 228 and to cover the oxide 226, to provide an electrode or an electrical connection arrangement (e.g., pickup arrangement) of the semiconductor device/structure. The deposited metallic material is electrically connected with at least the p+ region 230 and the n-type region 222.

In this embodiment, the polysilicon body 218 provides an electrode that can operate as a gate electrode, the polysilicon body 210 provides an electrode that can operate as a shield electrode, the oxide arranged on the side of the polysilicon body 218 can operate as gate oxide, the oxide arranged between the two polysilicon bodies 210, 218 can operate as inter-poly oxide, the oxide arranged around the polysilicon body 210 can operate as shield oxide, the p-type region 224 can operate as a body region, the n-type region 222 can operate as a source region, and the p+ region 230 can operate as a contact.

A skilled person appreciates that the stages in Figs. 2A to 2O may correspond to the steps in method 100 in a different way than that described.

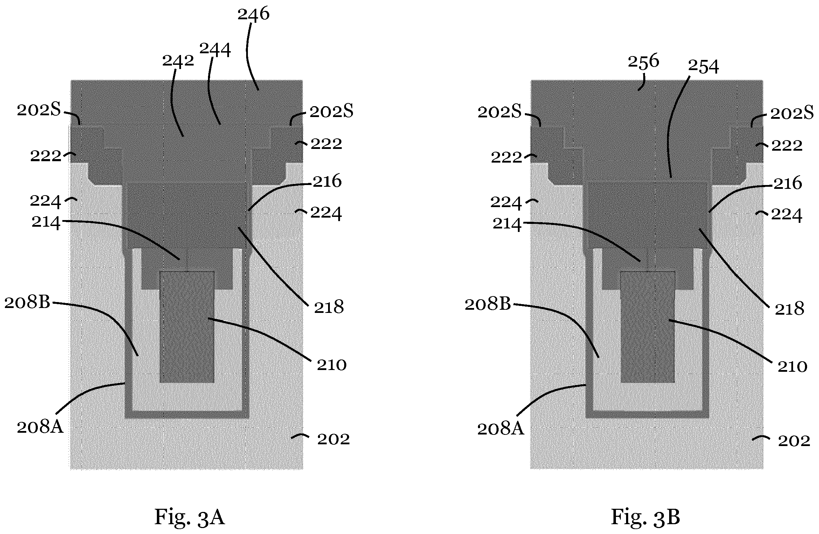

Fig. 3A illustrates a variation to the stage of the method in Fig. 2L in one embodiment of the invention. The stage shown in Fig. 3A can replace the stage shown in Fig. 2L.

In the stage shown in Fig. 3A, oxide (silicon dioxide) is deposited in the trench 206 on the sacrificial oxide layer 220, to fill the remaining space of the trench 206. The deposited oxide 242 is then subjected to (partial) chemical mechanical polishing, so that the top surface of the oxide 242 is generally flush with the surface 202S of the substrate 202. Then, the exposed surface of the silicon substrate 202, i.e., the surface 202S, is lightly oxidized, and, silicon nitride is deposited using chemical vapor deposition such as low pressure chemical vapor deposition, on the semiconductor structure to form a silicon nitride layer 244. The light oxidation of the surface 202S can prevent high interfacial stress between the surface 202S and the silicon nitride layer 244 and can prevent nitrogen in the silicon nitride layer 244 from diffusing into the silicon substrate 202. Oxide (silicon dioxide) is further deposited on the silicon nitride layer 244 to form an oxide layer 246.

After the stage shown in Fig. 3A, the part of the oxide layer 246 above the surface 202S is removed by etching (oxide etching), then the part of the silicon nitride layer 244 above the surface 202S is removed by etching, and then the part of the oxide 242 above the surface 202S is removed by etching (oxide etching). This exposes the surface 202S, i.e., the surface of the n-type region 222, for subsequent processing in the stage shown in Fig. 2M (except that in this embodiment, a silicon nitride layer 244 would be present on the oxide 226). In this embodiment, the silicon nitride layer 244 can be used as a shield during oxide etching to prevent excessive etching of the oxide 242. Thus, the silicon nitride layer 244 can also be referred to as a barrier layer.

Fig. 3B illustrates a variation to the stage of the method in Fig. 2L in one embodiment of the invention. The stage shown in Fig. 3B can replace the stage shown in Fig. 2L.

In the stage shown in Fig. 3B, exposed surface of the silicon substrate 202, i.e., the top surface of the semiconductor structure including the surface 202S is lightly oxidized, then silicon nitride is deposited using chemical vapor deposition such as low pressure chemical vapor deposition, on the semiconductor structure to form a silicon nitride layer or lining 254 that covers the semiconductor structure (the top surface of the semiconductor structure including the surface 202S and the remaining space of the trench). The light oxidation of the surface 202S can prevent high interfacial stress between the top surface of the semiconductor structure and the silicon nitride layer 244 and can prevent nitrogen in the silicon nitride layer 244 from diffusing into the silicon substrate 202. Then, borophosphosilicate glass (BPSG) is deposited on the silicon nitride lining 254 such that an oxide arrangement (provided by BPSG) 256 is formed on the semiconductor structure to cover the silicon nitride lining 254. A lower portion of the oxide arrangement 256 fills the remaining space of the trench 206. A reflow process is performed on the BPSG to form a flat top surface of the oxide arrangement 256.

In one embodiment, after the stage shown in Fig. 3B, the part of the oxide arrangement 256 above the surface 202S is removed by chemical mechanical polishing and/or etching (oxide etching), and the part of the silicon nitride lining 254 above the surface 202S is removed by etching. This exposes the surface 202S, i.e., the surface of the n-type region 222, for subsequent processing in the stage shown in Fig. 2M (except that in this embodiment, a silicon nitride lining 254 would remain in the trench below the oxide arrangement 256). In this embodiment, the silicon nitride lining 254 can be used as a shield during oxide etching and can prevent out diffusion of boron and phosphorus from the oxide arrangement 256 into the n-type region 222.Thus, the silicon nitride lining 254 can also be referred to as a barrier layer.

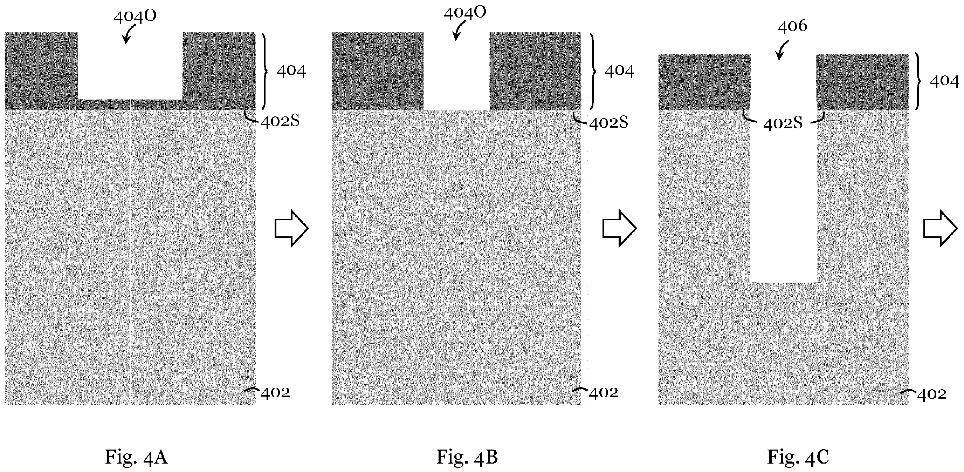

Figs. 4A to 4H illustrate various stages in part of a method of forming a self-aligned contact in a shielded gate trench (SGT) MOSFET (only one cell is shown) in one embodiment of the invention. The part of the method illustrated using Figs. 4A to 4H can be considered as a more specific implementation example of part of the method 100 of Fig. 1.

Figs. 4A to 4H illustrate example operations of step 102 in method 100.

In the stage shown in Fig. 4A, a semiconductor structure is obtained. The semiconductor structure is obtained by forming an oxide-nitride-oxide (ONO) hard mask 204 on a top surface 402S of a n-type (silicon) epitaxial substrate 402. Specifically, the substrate 402 is first subjected to oxidation to a form an oxide (silicon dioxide) layer on the surface 402S. Then, silicon nitride is deposited over the oxide layer to form a silicon nitride layer that covers the oxide layer. Further oxide (silicon dioxide) is deposited on the silicon nitride layer to form another oxide layer that covers the silicon nitride layer. This other oxide layer is thicker than the oxide layer on the surface 402S. A photoresist is applied to the semiconductor structure, and a photolithographic mask (patterned) is applied over the semiconductor structure. With the photoresist and photolithographic mask applied, a portion of the upper thick oxide layer is etched to remove the entire thickness of the portion the thick oxide layer, and a corresponding portion of the silicon nitride layer is etched to reduce the thickness of the portion the thick oxide silicon nitride layer. The photoresist used is subsequently stripped. As a result of the above processing, an opening 404O that extends from the top surface of the mask 404 into the upper oxide layer and the middle silicon nitride layer is formed in the mask 404. The entire surface 402S remains covered by the mask 404.

In the stage shown in Fig. 4B, the semiconductor structure obtained in Fig. 4A is further processed. First, a cleaning operation is performed on the semiconductor structure. Then, oxide (silicon dioxide) is deposited on the side wall and the base wall of the opening 404O. The size of the opening 404O is thus reduced. Afterwards, a portion of the oxide in the reduced-sized opening 404O is dry etched, then an underlying portion of the silicon nitride layer is etched, and finally an underlying portion of the oxide layer on the surface 402S. A portion of the surface 402S is thus exposed (and the remaining portion of the surface 402S is covered by the mask 404).

In the stage shown in Fig. 4C, the semiconductor structure obtained in Fig. 4B is processed to form a trench 406 that extends from the top surface of the semiconductor structure through the mask 404 and into the substrate 402. Specifically, silicon etching is performed on the exposed part of the surface 402S to remove the underlying portion of the substrate 402. A cleaning operation is then performed on the semiconductor structure. Then, a sacrificial oxide (silicon dioxide) layer is formed by thermal oxidation and is subsequently removed by isotropic etching.

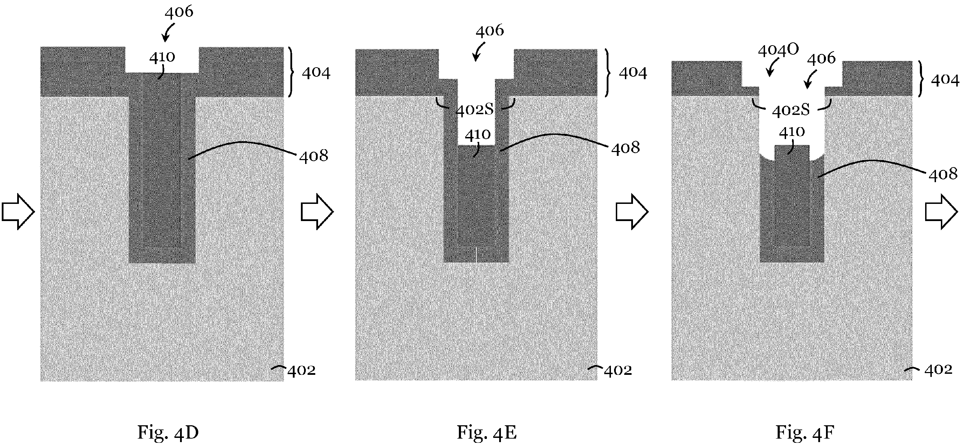

In the stage shown in Fig. 4D, the semiconductor structure obtained in Fig. 4C is processed to provide an oxide (silicon dioxide) layer 408 on the base wall and side wall of the trench and a polysilicon body in a space defied by the oxide layer. Specifically, oxide is first formed on the base wall and side wall of the trench 406 using deposition or thermal oxidation. Then, a polysilicon material is deposited into the trench 406 in a space defined by the oxide in the trench, to form a polysilicon body 410. In this example, the top surface of the polysilicon body 410 is generally flush with the top surface of the oxide layer 408. Annealing operation is then performed on the polysilicon body 410.

In the stage shown in Fig. 4E, the semiconductor structure obtained in Fig. 4D is processed to remove part of the polysilicon body 410. Specifically, the polysilicon body 410 is subjected to chemical mechanical polishing and/or is etched back to reduce its size such that the top surface of the polysilicon body 210 is disposed away from the surface 402S.

In the stage shown in Fig. 4F, the semiconductor structure obtained in Fig. 4E is processed to remove some of the oxide on the semiconductor structure. Specifically, the exposed oxide on the semiconductor structure is wet etched to remove the upper oxide layer of the mask 404, the oxide lining the side wall of the opening 404O of the mask, and a portion of the oxide layer 408 arranged in the trench 406. As a result of the etching, the top surface of the polysilicon body 410 projects beyond the top surface of the oxide layer 408 arranged in the trench 406. A cleaning operation is performed on the semiconductor structure.

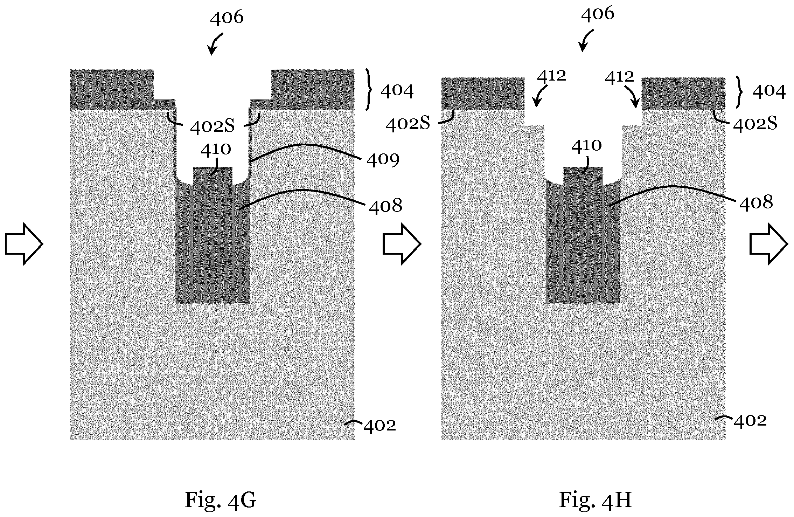

In the stage shown in Fig. 4G, the semiconductor structure obtained in Fig. 4F is processed to form a thin sacrificial oxide layer 409 on the side wall at an upper end of the trench 406. The thin sacrificial oxide layer 409 is formed by thermal oxidation of the exposed substrate portion in the trench.

In the stage shown in Fig. 4H, the semiconductor structure obtained in Fig. 4G is processed to form a divot 412. Specifically, a dry etching operation is first performed on the mask 404 to remove the portion of the silicon nitride layer providing the side wall of the trench 406. This exposes a corresponding portion of the underlying oxide layer of the mask 404. Then, the thin sacrificial oxide layer 409 and the portion of the underlying oxide layer of the mask 404 are isotropically etched and removed, to exposed a corresponding portion of the underlying surface 402S provided by the substrate. A silicon etching operation is performed to etch the corresponding portion of the underlying surface 402S, to form a divot 412 at the upper or top end of the trench 406. As shown in Fig. 4H, the formed divot 412 is integrated with the trench 406 (i.e., they provide a continuous space) to provide a stepped mouth portion at the upper or top end of the trench.

In one embodiment, after the stage shown in Fig. 4H, the remaining parts of the mask 404 may be removed, and the method may proceed to the stage shown in Fig. 2G, to perform the rest of the stages provided in Figs. 2G to 2O.

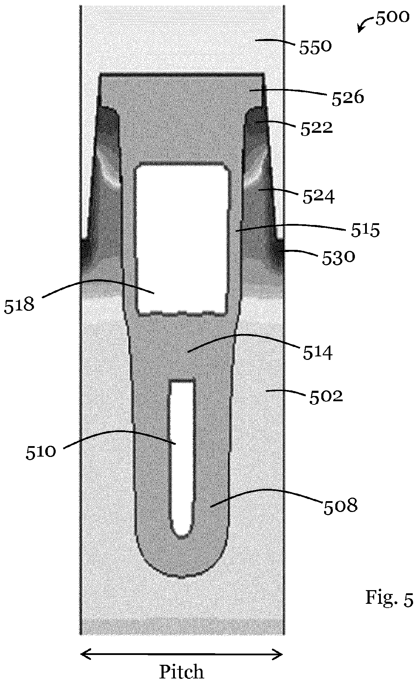

Fig. 5 shows a cell 500 of a SGT MOSFET formed using the method of Figs. 2A to 2O in one embodiment of the invention. The cell 500 includes a n-type epitaxial substrate 502, and a vertical shielded gate trench extending into the n-type epitaxial substrate 502. The vertical shielded gate trench includes a trench containing a gate electrode 518 (polysilicon body) and a shield electrode 510 (polysilicon body) disposed below and aligned vertically with the gate electrode 518. The remaining space of the trench is filled by a dielectric arrangement formed by silicon dioxide. The dielectric arrangement includes a lower end portion operable as shield oxide 508, a middle portion between the two polysilicon bodies 510, 518 operable as inter-poly dielectric 514, an upper portion disposed on the lateral sides of the polysilicon body 518 operable as gate oxide 515, and an upper most portion disposed above the gate electrode 518 operable as inter layer dielectric 526. A p-type body region 524 is provided adjacent to, and is spatially (vertically) aligned with the gate electrode 518 (and gate oxide 515). A n-type source region 522 is formed above the p-type body region 524. A p+ contact region 530 is formed on one side of the p-type body region 524 opposite to the gate electrode 518 (and gate oxide 515). The p+ contact region 530 and the n-type source region 522 together define a contact opening on a lateral side of the cell 500. A metallic element or arrangement operable as electrode 550 or electrical contact covers the trench and fills the contact opening.

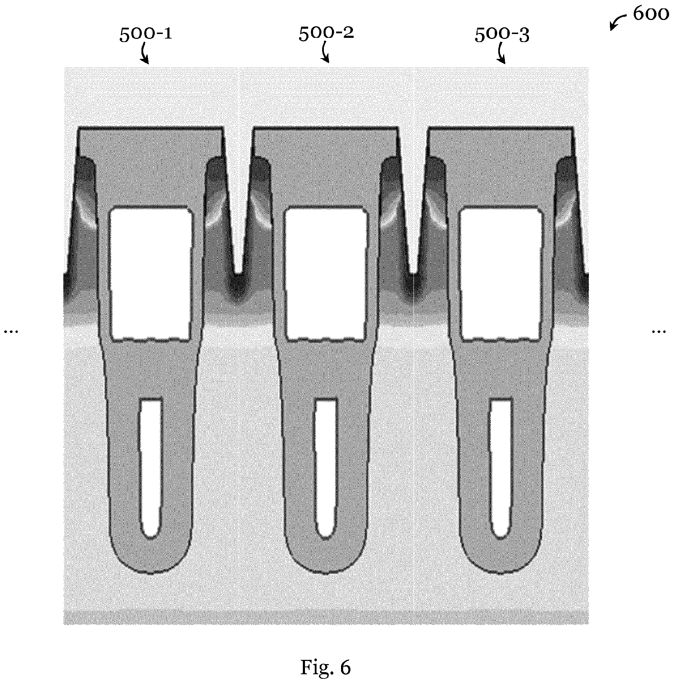

Fig. 6 shows a SGT MOSFET with a cell array 600 in one embodiment of the invention. In this embodiment, the cell array 600 includes three cells 500-1, 500-2, 500-3 arranged adjacent one another in parallel. Each respective one of the cells 500-1, 500-2, 500-3 is the same as the cell 500 of Fig. 5.

It will be appreciated by a person skilled in the art that variations and/or modifications can be made to the described and/or illustrated embodiments of the invention to provide other embodiments of the invention, without departing from the scope of the invention as defined by the accompanying claims. In other words, the described and/or illustrated embodiments of the invention should be considered in all respects as illustrative, not restrictive.

In some of the above embodiments, only a single cell of a semiconductor device/structure is illustrated or described. A skilled person appreciates that the semiconductor device/structure can have any number of cells, preferably multiple ones of the cells of the present invention arranged in parallel and one adjacent another. In some examples, the cells or the semiconductor device/structure is arranged in a single die or single chip. The level of electrical conductivity of each of the p- and n- type regions can be controlled, e.g., by the levels of doping. The type of conductivity of the various parts or components can be different from those specifically illustrated.

Some possible (non-exhaustive) variations and/or modifications are as follows. For example, the shape, size, arrangement, and/or spatial configuration of the components in the cell of the semiconductor device/structure can be different from those specifically described and/or illustrated. For example, the cell of the semiconductor device/structure may include additional components not described and/or illustrated. For example, the cell of the semiconductor device/structure may lack one or more of the components described and/or illustrated. For example, the semiconductor device/structure can be made using techniques different from those specifically described.

## Claims

1. A method of forming a self-aligned contact in a semiconductor device, comprising:
(a) obtaining a semiconductor structure comprising: a substrate with a surface comprising a first portion etched to form a divot and a second portion adjacent the first portion, and a trench extending in a first direction from the surface into the substrate;
(b) arranging a first electrode in the trench;
(c) arranging a dielectric on the semiconductor structure to cover, at least, a wall of the divot provided by the substrate and the second portion of the surface;
(d) implanting, in the substrate, impurities of a first conductivity type and a second conductivity type to form a first region of the first conductivity type and a second region of the second conductivity type, the first region being spatially aligned with the first electrode in a second direction perpendicular to the first direction and the second region is arranged between the first region and the dielectric;
(e) removing part of the dielectric to expose part of the second region;
(f) etching the exposed part of the second region and a corresponding part of the first region, to form an opening that extends in the first direction into the first region and the second region; and
(g) forming, in part of the first region, a third region of the first conductivity type with a higher level of conductivity than the first region, such that the third region is spatially aligned with the first region and the first electrode in the second direction, and that the third region provides a wall portion of the opening for operating as a contact of the semiconductor device.

2. The method of claim 1, wherein the semiconductor structure obtained in (a) further comprises:
a second electrode, and a dielectric arrangement arranged on a base wall and a sidewall of the trench, the dielectric arrangement surrounds the second electrode in the trench.

3. The method of claim 1 or 2, wherein obtaining the semiconductor structure in (a) comprises:
obtaining a semiconductor structure comprising: the substrate, a mask formed on the surface of the substrate, and the trench extending in the first direction through the mask and into the substrate;
removing a first part of the mask to expose the first portion of the surface;
etching the exposed first portion of the surface to form the divot when the second portion of the surface is covered by a second part of the mask; and
removing the second part of the mask to expose the second portion of the surface.

4. The method of claim 3, wherein the first part of the mask is at an open end of the trench.

5. The method of claim 3 or 4,
wherein removing the first part of the mask comprises etching the mask; and
wherein removing the second part of the mask comprises etching the mask.

6. The method of any one of claims 1 to 5, wherein the divot is integrated with the trench to provide an enlarged mouth portion at an open end of the trench.

7. The method of claim 6, wherein the enlarged mouth portion is a stepped portion.

8. The method of any one of claims 1 to 7, wherein arranging the first electrode in the trench in (b) comprises:
depositing polysilicon in the trench.

9. The method of any one of claims 1 to 8, wherein arranging the dielectric on the semiconductor structure in (c) comprises:
arranging the dielectric on the semiconductor structure obtained after (b) to cover the first electrode, the wall of the divot provided by the substrate, and the second portion of the surface.

10. The method of any one of claims 1 to 9, wherein the forming in (g) comprises:
implanting, in the substrate, impurities of the first conductivity type with a higher doping level than the first region to form the third region.

11. The method of claim 10,
wherein the first region is a p-type region is operable as a body region;
wherein the second region is a n-type region is operable as a source region; and
wherein a p-n junction is defined by the first region and the second region.

12. The method of any one of claims 1 to 11, further comprising:
after the implanting in (d) and prior to the removing in (e), depositing a dielectric material on the semiconductor structure to fill a remaining space of the trench.

13. The method of claim 12, further comprising:
forming a barrier layer on the deposited dielectric material.

14. The method of any one of claims 1 to 11, further comprising:
after the implanting in (d) and prior to the removing in (e), forming a barrier layer on the semiconductor structure to cover a remaining space of the trench; and
depositing a dielectric material on the barrier layer to fill the remaining space of the trench.

15. A semiconductor device comprising a contact formed using the method of any one of claims 1 to 14.
